# EUROPEAN PATENT APPLICATION

(11) **EP 2 182 790 A2**
(43) Date of publication of application: **05.05.2010**
(21) Application number: 09013823.1
(22) Date of filing: 03.11.2009
(51) Int. Cl.: H05K 13/00

(54) **Method of mounting electronic component and electronic component mounting apparatus**

(30) Priority: 04.11.2008 JP 2008283779
(71) Applicant: Hitachi High-Tech Instruments Co., Ltd., Ora-gun, Gunma, 370-0596 (JP)
(72) Inventor: Oyama, Kazuyoshi, Tochigi (JP); Onoguchi, Yoshihiro, Oragun, Gunma (JP); Kashitani, Hisayoshi, Otha-shi, Gunma (JP)
(74) Representative: Glawe, Delfs, Moll

(57) **Abstract**

In an electronic component mounting apparatus, when a replacement work of a component feeding unit (13) is performed on a component feeding device on one side, the operating ratio of a beam (7,8) on the one side is increased to enhance the production efficiency. While a component feeding unit (13) of a first component feeding device (3) on a front side is being replaced, a beam (7) on the front side moves onto a second component feeding device (5) on a rear side, a first mounting head (11) moves between a printed board (P) on a carrying device and the second component feeding device (5) in the similar manner to a second mounting head (10), and suction nozzles (101/111) mounted on each of the first and second mounting heads (10,11) pick up electronic components from the second component feeding device (5) and mounts the electronic components on the printed board (P).

## Description

The invention relates to a method of mounting electronic components by an electronic component mounting apparatus that picks up electronic components from component feeding devices by suction by suction nozzles and mounts the electronic components on a positioned printed board, the electronic component mounting apparatus, and a method of deciding an order of mounting electronic components by the electronic component mounting apparatus. In particular, the invention relates to a method of mounting electronic components by an electronic component mounting apparatus that has a carrying device carrying a printed board, component feeding devices mounted on either side of this carrying device, on which a plurality of component feeding units supplying electronic components is detachably mounted, a pair of beams movable in one direction by drive sources, and mounting heads each having suction nozzles and movable along each of the beams by respective drive sources, and the electronic component mounting apparatus.

### Description of the Related Art:

This type of electronic component mounting apparatus is disclosed in, for example, Japanese Patent Application publication No. 2006-286707 and so on. In general, component feeding devices supplying electronic components are respectively provided on both sides of a carrying device carrying a printed board, and a pair of beams each having a mounting head are provided for the component feeding devices respectively. In general, each of the beams corresponds to each of the component feeding devices and the mounting head of one beam picks up electronic components from the corresponding component feeding device only and mounts the electronic components on a printed board.

However, in the case where the component feeding devices are mounted on both the sides of the carrying device respectively, when a component feeding unit mounted on the component feeding device on one side need be replaced by other because of the changes of the type of printed boards to be produced and the types of electronic components to be mounted, the mounting head on this side where the component feeding unit need be replaced stops its operation and does not work for mounting electronic components on a printed board until the replacement work of the component feeding unit is completed. Therefore, the operating ratio of this mounting head, i.e., the beam on one side where this mounting head is mounted is decreased and the production efficiency is degraded.

Therefore, the invention is directed to an electronic component mounting apparatus that enhances the operating ratio of the beam and enhances the production efficiency when the component feeding unit is replaced.

### SUMMARY OF THE INVENTION

The invention provides a method of mounting an electronic component by an electronic component mounting apparatus, the apparatus including: a carrying device (2) having a first side and a second side and carrying a printed board (P) in a first direction; a first component feeding device (3) placed on the first side of the carrying device (2) and including a plurality of component feeding units (13) supplying electronic components; a second component feeding device (5) placed on the second side of the carrying device (2) and including a plurality of component feeding units (13) supplying electronic components; a first beam (8) and a second beam (7) that are movable in a second direction; a first mounting head (11) including a first suction nozzle (111) and movable along the first beam (8); and a second mounting head (10) including a second suction nozzle (101) and movable along the second beam (7), the method including moving the first suction nozzle (111) and the second suction nozzle (101) by moving the first beam (8), the second beam (7), the first mounting head (11) and the second mounting head (10) so that the first suction nozzle (111) and the second suction nozzle (101) pick up electronic components from the second component feeding device (5) and mount the picked up electronic components on the printed board (P) when the component feeding unit (13) of the first component feeding device (3) is replaced by other component feeding unit.

The invention also provides an electronic component mounting apparatus including: a carrying device (2) having a first side and a second side and carrying a printed board (P) in a first direction; a first component feeding device (3) placed on the first side of the carrying device (2) and including a plurality of component feeding units (13) supplying electronic components; a second component feeding device (5) placed on the second side of the carrying device (2) and including a plurality of component feeding units (13) supplying electronic components; a first beam (8) and a second beam (7) that are movable in a second direction; a first mounting head (11) including a first suction nozzle (111) and movable along the first beam (8); a second mounting head (10) including a second suction nozzle (101) and movable along the second beam (7), and a control device (16) controlling the movement of the first beam (8), the second beam (7), the first mounting head (11) and the second mounting head (10) so that the first suction nozzle (111) and the second suction nozzle (101) pick up electronic components from the second component feeding device (5) and mount the picked up electronic components on the printed board (P) when the component feeding unit (13) of the first component feeding device (3) is replaced by other component feeding unit.

### BRIEF DESCRIPTION OF THE DRAWINGS

Fig. 1 is a schematic plan view of an electronic component mounting apparatus of a first embodiment.
Fig. 2 is a control block diagram.
Fig. 3 is a view showing component disposition data for a component feeding device on a rear side.
Fig. 4 is a view showing component disposition data for a component feeding device on a front side.
Fig. 5 is a view showing mounting data for a board type A.
Fig. 6 is a view showing mounting data for a board type B.
Fig. 7 is a view showing mounting data for a board type C.
Fig. 8 is a view explaining a change of component disposition data between before and after the replacement of the component feeding device on the front side.
Fig. 9 is a view showing mounting data for a board type D.
Fig. 10 is a schematic plan view of the electronic component mounting apparatus when the beam on the front side (on the front side) moves onto the component feeding device on the rear side (on the back side) in the first embodiment.

### DETAILED DESCRIPTION OF THE INVENTION

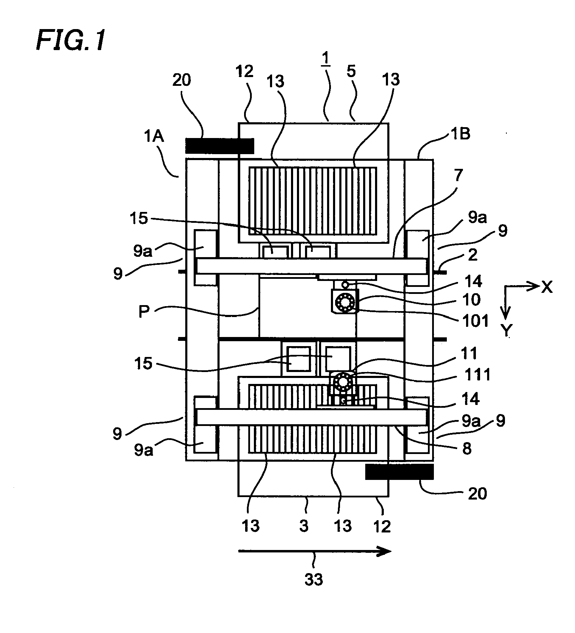

Hereafter, a first embodiment of an electronic component mounting apparatus for mounting electronic components on a printed board will be described referring to Figs. 1 to 4. An electronic component mounting apparatus 1 is provided with a carrying device 2 carrying a printed board P in a X direction, a component feeding device 5 such as a cart mounted on one side, i.e., the rear side of this carrying device 2 (on the back side of the set apparatus or on the upper side in Fig. 1), on which, for example, a plurality of component feeding units 13 supplying electronic components is detachably arrayed, a component feeding device 3 such as a cart mounted on the other side, i.e., the front side of the carrying device 2 (on the front side of the set apparatus or on the lower side in Fig. 1), on which, for example, a plurality of component feeding units 13 supplying electronic components is detachably arrayed, a pair of beams 7, 8 movable in one direction by drive sources, and mounting heads 10, 11 each having suction nozzles and movable along the beams 7, 8 by drive sources respectively.

The carrying device 2 is disposed in the middle portion of the electronic component mounting apparatus 1, and has a board supply portion receiving a printed board P from an upstream device, a positioning portion positioning the printed board P supplied from the board supply portion in order to mount electronic components held by suction by the suction nozzles 101, 111 of the mounting heads 10, 11, and a discharging portion receiving the printed board P on which the electronic components are mounted at the positioning portion and discharging it to a downstream device.

The component feeding devices 3, 5 have feeder bases 12, and the plurality of component feeding units 13 is detachably arrayed on the lanes of each of the feeder bases 12 to supply various electronic components to those component pickup portions (component suction positions) one by one.

The pair of beams 7, 8 on the rear and front sides that are respectively located on one side (on the component feeding device 5 side) and on the other side (on the component feeding device 3 side) and extend in the X direction are moved in the Y direction separately by sliders fixed to each of the beams sliding along a pair of left and right guides extending in the front to rear direction, driven by Y direction linear motors 9. Each of the Y direction linear motors 9 has a pair of upper and lower stationary members fixed to each of a pair of left and right bases 1 A, 1 B therealong, and moving members 9a fixed to lower portions of attachment boards respectively provided on both the ends of each of the beams 7,8.

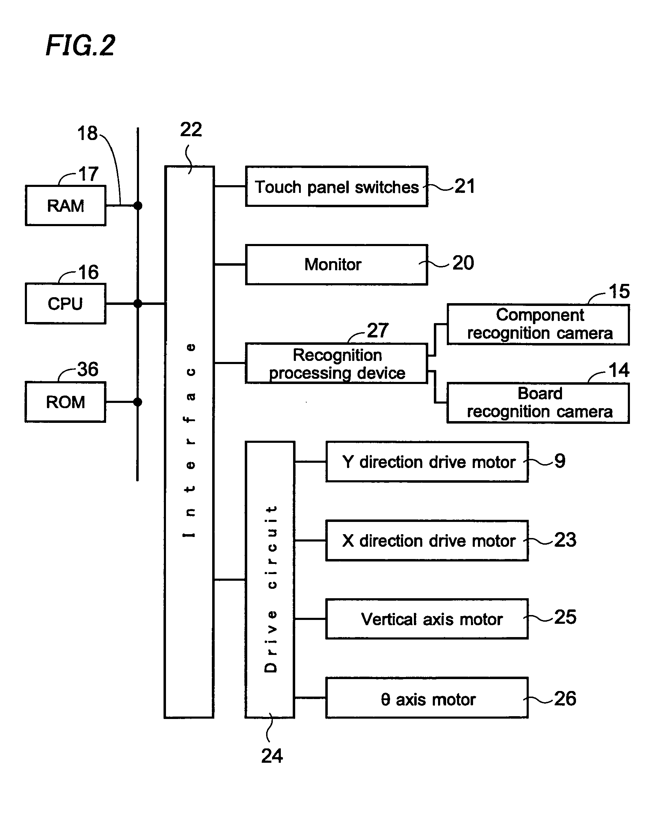

The mounting heads 10, 11 that move along guides in the longitudinal direction (the X direction) of the beams 7, 8 by X direction linear motors 23 (Fig. 2) are provided on the beams 7, 8 on the inside respectively, and each of the X direction linear motors has a pair of front and rear stationary members fixed to each of the beams 7, 8 and a moving member located between the stationary members that is provided on each of the mounting heads 10, 11.

Therefore, the mounting heads 10, 11 are provided on the beams 7, 8 on the inside so as to face each other, and move above a printed board P on the positioning portion of the carrying device 2 or above the component pickup positions of the component feeding units 13 of the component feeding devices 3, 5.

For example, the four suction nozzles 101, 111 are provided on the mounting heads 10, 11 respectively at predetermined intervals in a circle, being pushed downward by springs, and the suction nozzles 101, 111 in the 3 o'clock and 9 o'clock positions of each of the mounting heads 10, 11 may pick up electronic components simultaneously from the arrayed component feeding units 13. Each of the suction nozzles 101, 111 is vertically movable by a vertical axis motor 25 (Fig. 2) and each of the mounting heads 10, 11 is rotatable about the vertical axis by a θ axis motor 26 (Fig. 2). As a result, each of the suction nozzles 101, 111 of the mounting heads 10, 11 has a capability of moving in the X and Y directions, rotating about the vertical axis, and moving vertically.

A board recognition camera 14 is provided on each of the mounting heads 10, 11, that takes an image of a positioning mark given to a positioned printed board P. Furthermore, component recognition cameras 15 sequentially take images of electronic components picked up by suction by the suction nozzles.

Fig. 2 shows a control block for the control of the electronic component mounting of the electronic component mounting apparatus 1, and this will be described below. CPU (a central processing unit) 16 controls the parts of the electronic component mounting apparatus 1, and ROM (a read only memory) 36 storing programs relating to this control and RAM (a random access memory) 17 storing various data are connected to the CPU 16 through bus lines 18. A monitor 20 displaying an operation screen etc and touch panel switches 21 as input means on a display screen of this monitor 20 are also connected to the CPU 16 through an interface 22. The Y direction linear motor 9 etc are further connected to the CPU 16 through a drive circuit 24 and the interface 22.

NC data is stored in the RAM 17, corresponding to respective types of printed boards P to be produced (board types), and the NC data includes operation data, setup data, mounting data and so on. The operation data includes comments as the names of the NC data, the sizes of printed boards in X and Y directions, the thicknesses of printed boards, the presence or absence of pre-mounted components, the heights of the pre-mounted components, and a board finishing mode. The RAM 17 further stores component disposition data that is previously set so as to avoid the replacement work of the component feeding unit 13 of the component feeding devices 3, 5 as much as possible, even when the board type for production is changed, by mounting component feeding units 13 having electronic components suppliable to printed boards of plural board types.

For example, when three types of boards, i.e., a printed board of a board type A (hereafter, referred to as an A-type printed board), a printed board of a board type B (hereafter, referred to as a B-type printed board) and a printed board of a board type C (hereafter, referred to as a C-type printed board) are to be produced, the component disposition data are previously set, indicating the types of electronic components to be disposed and the lanes for disposing these electronic components on the feeder bases 12 of the component feeding devices 3, 5, i.e., the way of disposition of the component feeding units supplying the electronic components in the component feeding device 3 and the component feeding device 5.

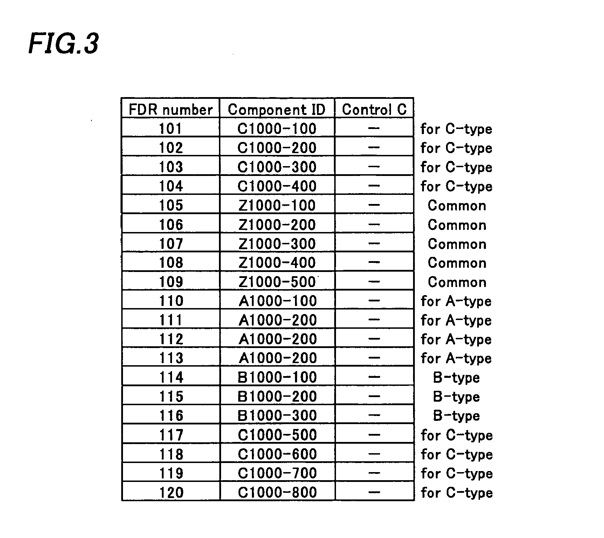

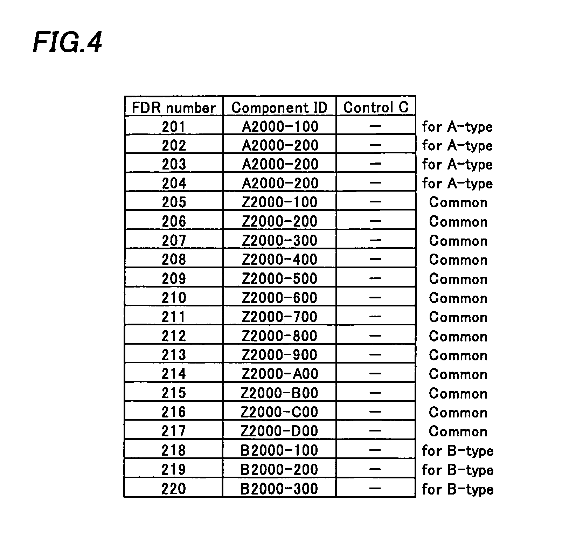

When the A-type printed board, the B-type printed board and the C-type printed board are to be produced in order, these component disposition data are set so as to avoid a need to replace the component feeding units disposed on the component feeding device 3 and the component feeding device 5 by others when the production is switched from the A-type printed board to the B-type printed board and from the B-type printed board to the C-type printed board, and so as to replace the component feeding units by other component feeding units supplying components for a next printed board to be produced after the C-type printed board in parallel with the production of the C-type printed board, and the data are as shown in Figs. 3 and 4.

In detail, as shown in the component disposition data of Fig. 3, component feeding units 13 supplying components of component types (hereafter, referred to as component ID) C1000-100 etc for the C-type printed board are arrayed on both the sides of the feeder base 12 of the component feeding device 5 on the rear side, for example, on the lanes of the feeder lane numbers (FDR numbers) 101 to 104. Furthermore, component feeding units 13 supplying components of the component ID Z1000-100 etc that are commonly used for the A-type printed board, the B-type printed board and the C-type printed board, component feeding units 13 supplying components of the component ID A1000-100 etc for the A-type printed board, and component feeding units 13 supplying components of the component ID B1000-100 etc for the B-type printed board are arrayed on the center lanes of the feeder lane numbers (FDR numbers) 105 to 116 on the feeder base 12.

Furthermore, as shown in the component disposition data of Fig. 4, component feeding units 13 supplying components of the component ID A2000-100 etc for the A-type printed board are arrayed on one side of the feeder base 12 of the component feeding device 3 on the front side, for example, on the lanes of the feeder lane numbers (FDR numbers) 201 to 204. Furthermore, component feeding units 13 supplying components of the component ID B2000-100 etc for the B-type printed board are arrayed on the lanes of the feeder lane numbers (FDR numbers) 218 to 220 on the other side of the feeder base 12. Furthermore, component feeding units 13 supplying components of the component ID Z2000-100 etc commonly used for the A-type printed board, the B-type printed board and the C-type printed board are arrayed on the center lanes of the feeder lane numbers (FDR numbers) 205 to 217 on the feeder base 12. As shown in the disposition data of Figs. 3 and 4, the component feeding device 5 on the rear side has the component feeding units 13 that supply electronic components when the C-type printed board P is produced, and on the other hand, the component feeding device 3 on the front side has the component feeding units 13 that supply electronic components when both the A-type and B-type printed boards are produced. As described below, while the C-type printed board P is being produced, it is possible in the component feeding device 3 on the front side to replace the component feeding units 13 by component feeding units 13 for a next printed board to be produced.

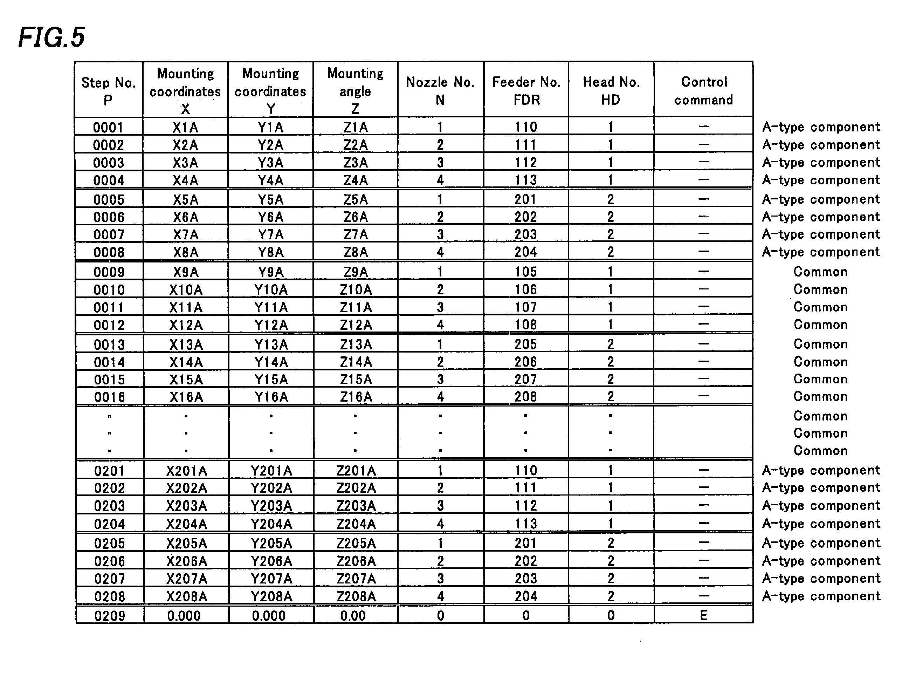

The mounting data for the A-type printed board is as shown in Fig. 5, for example. In this mounting data, in order to produce the A-type printed board P in the electronic component mounting apparatus 1 by picking up electronic components from the component feeding device 3 and the component feeding device 5 alternately and mounting the electronic components on the printed board P as effectively as possible, the order of picking up the electronic components from the component feeding device 3 and the component feeding device 5 is optimized previously.

The mounting data shown in Fig. 5 includes, in mounting order (for each of the step numbers), data on the mounting coordinates of each of the electronic components on the printed board P in the X direction (the right side of Fig. 1 is the plus) and the Y direction (the lower side of Fig. 1 is the plus) using the left upper corner of the printed board P as the origin, data on the mounting angles, data on the numbers of the suction nozzles (shown by "1" to "4"), data on the disposition numbers of the component feeding units (FDR), data on the numbers of the mounting heads 10, 11 (the mounting head 10 mounted on the beam 7 on the rear side is indicated by "1", and the mounting head 11 mounted on the beam 8 on the front side is indicated by "2"), and so on, and stored in the RAM 17.

According to the mounting data shown in Fig. 5, in the step numbers "0001" to "0004" and "0009" to "0012"..., the mounting head 10 (the head number "1") mounted on the beam 7 on the rear side is used to mount the electronic components on the printed board P. And in the step numbers "0005" to "0008" and "0013" to "0016", the mounting head 11 (the head number "2") mounted on the beam 8 on the front side is used to mount the electronic components on the printed board P. It means that the mounting head 10 on the rear side and the mounting head 11 on the front side alternately pick up electronic components from the component feeding device 5 on the rear side and the component feeding device 3 on the front side and mount the electronic components on the printed board P.

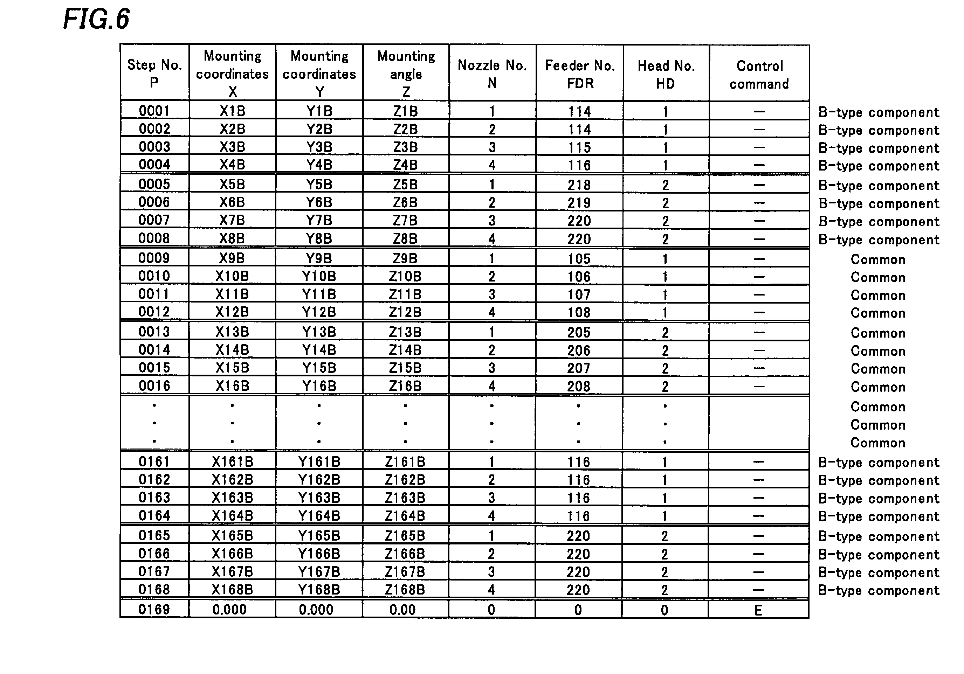

Furthermore, the mounting data previously set for the B-type printed board that is to be produced next after the A-type printed board, as shown in Fig. 6, is stored in the RAM 17. In this mounting data, in order to produce the B-type printed board P in the electronic component mounting apparatus 1 by picking up electronic components from the component feeding device 3 and the component feeding device 5 alternately and mounting the electronic components on the printed board P as effectively as possible, the order of picking up the electronic components from the component feeding device 3 and the component feeding device 5 is optimized previously.

Furthermore, the mounting data shown in Fig. 6 includes, in the similar manner to the mounting data shown in Fig. 5, in mounting order (for each of the step numbers), data on the mounting coordinates of each of the electronic components on the printed board P in the X direction (the right side of Fig. 1 is the plus) and the Y direction (the lower side of Fig. 1 is the plus) using the left upper corner of the printed board P as the origin, data on the mounting angles, data on the numbers of the suction nozzles (shown by "1" to "4"), data on the disposition numbers of the component feeding units (FDR), data on the numbers of the mounting heads 10, 11 (the mounting head 10 mounted on the beam 7 on the rear side is indicated by "1", and the mounting head 11 mounted on the beam 8 on the front side is indicated by "2"), and so on, and stored in the RAM 17.

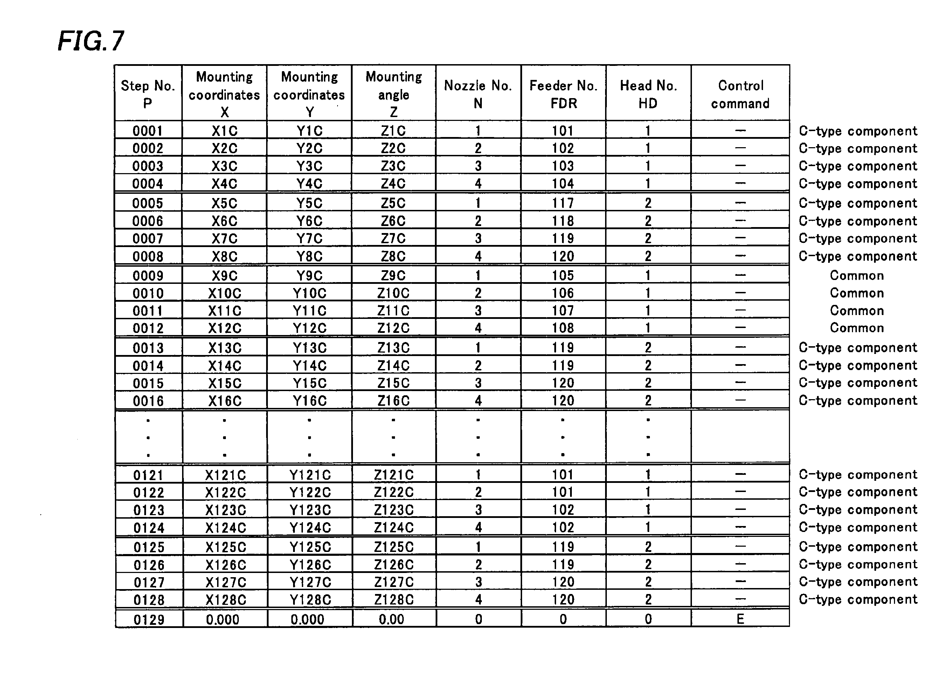

Furthermore, the mounting data previously set for the C-type printed board that is to be produced next after the B-type printed board, as shown in Fig. 7, is stored in the RAM 17. In this mounting data, in order to produce the C-type printed board P in the electronic component mounting apparatus 1 by picking up electronic components from the component feeding device 5 on the rear side only and mounting the electronic components on the printed board P as effectively as possible, the order of picking up the electronic components from the component feeding device 5 by both the mounting heads 10, 11 is optimized previously.

Furthermore, the mounting data shown in Fig. 7 includes, in the similar manner to the mounting data shown in Fig. 5 or 6, data on the mounting coordinates, data on the mounting angles, data on the numbers of the suction nozzles, data on the disposition numbers of the component feeding units (FDR), data on the numbers of the mounting heads 10, 11, and so on, and stored in the RAM 17.

For example, the mounting data is set so as to decide that the mounting head 11 (the head No.2) on the component feeding device 3 on the front side picks up the electronic components from the component feeding device 5 on the rear side that is on the other side in the step numbers "0005" to "0008", "0013" to "0016" and so on, for example.

According to the mounting data shown in Fig. 7, in the step numbers "0001" to "0004" and "0009" to "0012"..., the mounting head 10 (the head number "1") mounted on the beam 7 on the rear side is used to mount the electronic components on the printed board P. And in the step numbers "0005" to "0008" and "0013" to "0016", the mounting head 11 (the head number "2") mounted on the beam 8 on the front side moves onto the component feeding device 5 on the rear side picks up electronic components from the component feeding device 5, and mounts the picked up electronic components on the printed board P. It means that the mounting head 10 on the rear side and the mounting head 11 on the front side alternately pick up electronic components from the component feeding device 5 on the rear side and mount the electronic components on the printed board P.

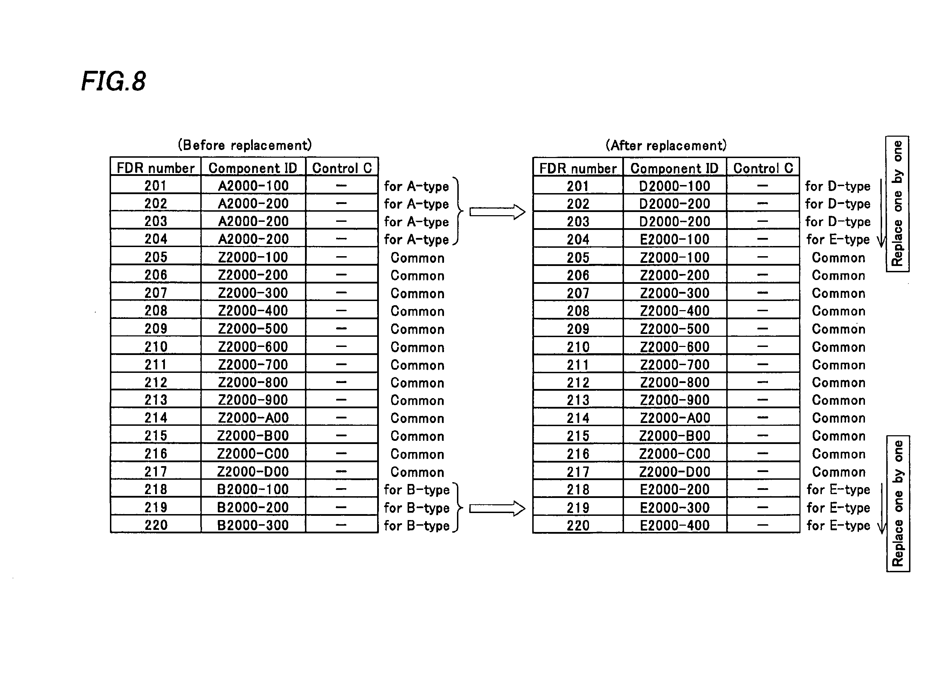

Fig. 8 is a view of disposition data before replaced (before changed) and disposition data after replaced (after changed) for D-type and E-type printed boards to be produced after the C-type printed board, that explains the replacement of the component feeding units 13 on the component feeding device 3 on the front side while the mounting head 10 on the rear side and the mounting head 11 on the front side are alternately picking up the electronic components from the component feeding device 5 on the rear side and mounting the electronic components on the printed board P based on the mounting data shown in Fig. 7. The disposition data after the replacement is stored in the RAM 17.

According to these component disposition data, before the replacement, the component feeding units 13 supplying the components of the component ID A2000-100 etc for the A-type printed board are arrayed on the lanes of the feeder lane numbers (FDR numbers) 201 to 204. After the replacement, component feeding units 13 supplying components of the component ID D2000-100 etc for the D-type printed board are arrayed on the lanes of the feeder lane numbers (FDR numbers) 201 to 203, and a component feeding unit 13 supplying components of the component ID E2000-100 for the E-type printed board is disposed on the lane of the feeder lane number (FDR number) 204.

Furthermore, before the replacement, the component feeding units 13 supplying the components of the component ID B2000-100 etc for the B-type printed board are arrayed on the lanes of the feeder lane numbers (FDR numbers) 218 to 220. After the replacement, component feeding units 13 supplying components of the component ID E2000-200 etc for the E-type printed board are arrayed on the lanes of the feeder lane numbers (FDR numbers) 218 to 220.

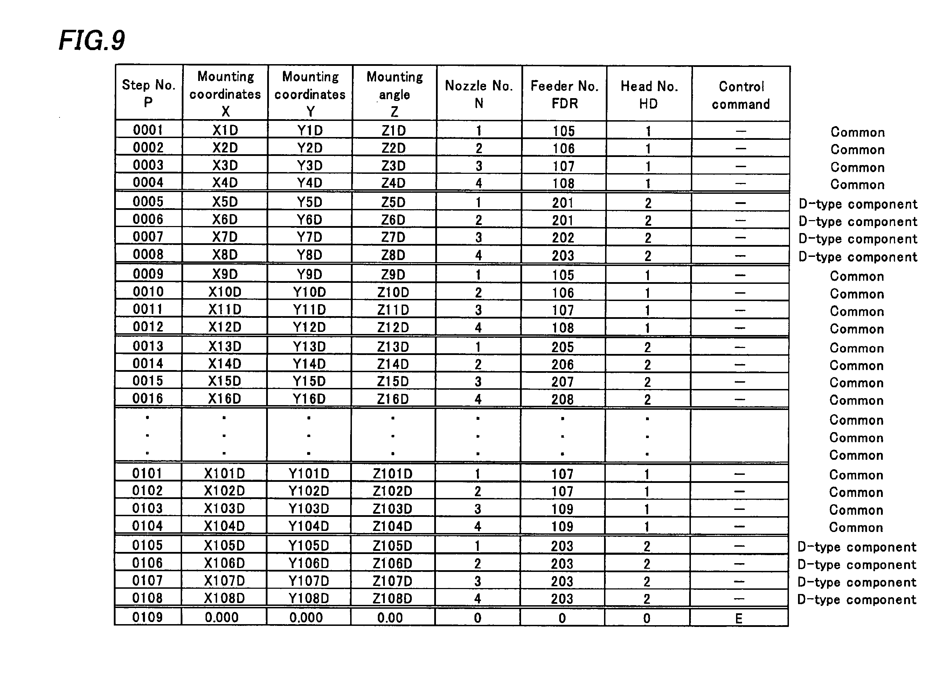

Furthermore, the mounting data shown in Fig. 9 that is previously set for the printed board of the board type D (hereafter, referred to as the D-type printed board) that is a next printed board to be produced after the board type C is stored in the RAM 17.

According to the mounting data shown in Fig. 9, in the step numbers "0001" to "0004" and "0009" to "0012"..., the mounting head 10 (the head number "1") mounted on the beam 7 on the rear side is used to mount the electronic components on the printed board P. And in the step numbers "0005" to "0008" and "0013" to "0016", the mounting head 11 (the head number "2") mounted on the beam 8 on the front side is used to mount the electronic components common to all the board types or the electronic components for the D-type printed board on the printed board P. It means that the mounting head 10 on the rear side and the mounting head 11 on the front side alternately pick up the electronic components from the component feeding device 5 on the rear side and the component feeding device 3 on the front side and mount the electronic components on the printed board P.

Component library data indicating the features of the electronic components by including shape data, recognition data, control data and component feeding data, and so on are also stored in the RAM 17.

A numeral 27 indicates a recognition processing device connected to the CPU 16 through the interface 22, that performs recognition processing of images taken by the board recognition cameras 14 and the component recognition cameras 15 and sends the processing result to the CPU 16. In detail, the CPU 16 outputs a command to perform the recognition processing (the calculation of the amount of shifting from a proper position and so on) to the images taken by the board recognition cameras 14 and the component recognition cameras 15 to the recognition processing device 27 and receives the recognition processing result from the recognition processing device 27.
An operation with the above structure will be described, hereafter.

First, an operator presses the touch panel switches 21 displayed on the monitor 20 to designate the board type A as the type of a printed board P to be produced, and presses an operation switch. Then the electronic component mounting apparatus 1 starts a production operation.

Then, as shown by an arrow 33, a printed board P is carried onto the supplying portion of the carrying device 2 from an upstream device (not shown), and the printed board P on the supplying portion is carried to the positioning portion, positioned in the planar and vertical directions, and fixed.

Once the printed board P is positioned, the beam 7 on the rear side moves in the Y direction by the sliders sliding along the guides extending in the front to rear direction, driven by the Y direction linear motor 9, and the mounting head 10 moves in the X direction by the X direction linear motor 23, reaches the position above the component pickup position of the component feeding unit 13, and lowers the suction nozzle 101 by the vertical axis motor to pick up an electronic component from the component feeding unit 13. At this time, by moving the mounting head 10 in the X direction and rotating the mounting head 10 and by vertically moving each of the suction nozzles 101, the plurality of suction nozzles 101 achieves picking up electronic components from the component feeding units 13 respectively.

When the printed board P is positioned, according to the mounting data for the board type A stored in the RAM 17 (Fig. 3), the CPU 16 controls the mounting heads 10, 11 of both the beams 7, 8 so that these pick up electronic components from the component feeding units 13 of the component feeding devices 3, 5 and mount the components on the printed board P in parallel (not "synchronously"). At this time, the CPU 16 controls both the beams 7, 8 so that these do not come close to each other in the Y direction more than need, and controls both the mounting heads 10, 11 so that these do not come close to each other in the X direction more than need, thereby preventing the mounting heads 10, 11 of both the beams 7, 8 from clashing against each other.

First, in the step numbers "0001" to "0004", the mounting head 10 (the head number "1" in Fig. 5) mounted on the beam 7 on the rear side picks up electronic components from the component feeding units 13 of the component feeding device 5 in order, and in parallel, in the step numbers "0005" to "0008", the mounting head 11 (the head number "2" in Fig. 5) mounted on the beam 8 on the front side picks up electronic components from the component feeding units 13 of the component feeding device 3 in order. In detail, in the step number "0001", the suction nozzle 101 of the nozzle number "1" of the mounting head 10 mounted on the beam 7 on the rear side picks up an electronic component from the component feeding unit 13 of the feeder lane number (FDR number) "110", and in parallel, in the step number "0005", the suction nozzle 111 of the nozzle number "1" of the mounting head 11 mounted on the beam 8 on the front side picks up an electronic component from the component feeding unit 13 of the feeder lane number (FDR number) "201". In this manner, each of the mounting heads 10, 11 picks up four electronic components by suction in the corresponding step numbers. At this time, the start of picking up the component by suction by the mounting head 11 on the front side and the start of picking up the component by suction by the mounting head 10 on the rear side, and the completion of picking up all the components by suction by the mounting head 11 on the front side and the completion of picking up all the components by suction by the mounting head 10 on the rear side may not be at the same time.

The suction nozzles 101, 111 of both the mounting heads 10, 11 are then moved upward after picking up the electronic components, and the mounting heads 10, 11 pass the component recognition cameras 15 thereabove. During this passing, the component recognition cameras 15 take images of the four electronic components held by the four suction nozzles 101, 111 of each of both the mounting heads 10, 11, and the recognition processing device 27 performs recognition processing to these images to recognize the positional shifts of the electronic components relative to the suction nozzles 101, 111.

Then, the board recognition cameras 14 mounted on the mounting heads 10, 11 of both the beams 7, 8 respectively are moved to above the printed board P and take images of a positioning mark given to the printed board P positioned on the carrying device 2, and the recognition processing device 27 performs recognition processing to these images to recognize the position of the printed board P. Then, each of the positional recognition results about the printed board P and each of the component recognition processing results are added to the mounting coordinates in the mounting data, and each of the suction nozzles 101, 111 mounts the electronic component on the printed board P after the correction of the positional shift.

In detail, the suction nozzles 101 of the mounting head 10 mounted on the beam 7 on the rear side holding the electronic components in the step numbers "0001" to "0004" supplied from the component feeding device 5 correct the positional shifts and mount the components on the printed board P sequentially. And in parallel with this, the suction nozzles 111 of the mounting head 11 mounted on the beam 8 on the front side holding the electronic components in the step numbers "0005" to "0008" supplied from the component feeding device 3 correct the positional shifts and mount the components on the printed board P sequentially. At this time, too, the CPU 16 controls the corresponding Y direction linear motors 9 and X direction linear motors 23 so that the mounting heads 10, 11 of both the beams 7, 8 do not clash against each other. At this time, the start of mounting the component by the mounting head 11 on the front side and the start of mounting the component by the mounting head 10 on the rear side, and the completion of mounting all the components by the mounting head 11 on the front side and the completion of mounting all the components by the mounting head 10 on the rear side may not be at the same time.

Then, in the step numbers "0009" to "0012", the mounting head 10 mounted on the beam 7 on the rear side picks up electronic components from the component feeding device 5 in order, and in parallel, in the step numbers "0013" to "0016", the mounting head 11 mounted on the beam 8 on the front side picks up electronic components from the component feeding device 3 on the front side. After the picking, as described above, both the mounting heads 10, 11 move, and during this moving, the recognition processing device 27 performs the recognition processing and recognizes the positional shifts of the electronic components relative to the suction nozzles.

Then, each of the positional recognition results about the printed board P and each of the component recognition processing results are added to the mounting coordinates in the mounting data, and each of the suction nozzles 101, 111 mounts the electronic component on the printed board P after the correction of the positional shift. In detail, the suction nozzles 101 of the mounting head 10 mounted on the beam 7 on the rear side holding the electronic components in the step numbers "0009" to "0012" by suction correct the positional shifts and mount the components on the printed board P sequentially. And in parallel with this, the suction nozzles 111 of the mounting head 11 mounted on the beam 8 on the front side holding the electronic components in the step numbers "0013" to "0016" by suction correct the positional shifts and mount the components on the printed board P sequentially.

Then, the electronic components stored in the component feeding device 5 and the component feeding device 3 are picked up by the mounting head 10 on the rear side and the mounting head on the front side in parallel, and mounted on each of printed boards P sequentially. When the mounting of the electronic components on one printed board P is completed, the printed board P is discharged by the carrying device 2, other printed board is carried in from the upstream, and electronic components are mounted on the printed board as described above. In this manner, the mounting head 10 on the rear side and the mounting head 11 on the front side cooperatively pick up the electronic components stored in the component feeding device 5 and the component feeding device 3 and mount the electronic components on the printed board P, thereby minimizing the mounting time.

When the production of the printed boards of the board type A is completed, the operator presses the touch panel switches 21 displayed on the monitor 20, and designates the pre-determined board type B as the type of a printed board P to be produced next and presses the operation switch to start the production operation of a printed board of the board type B.

Then, a printed board P of the board type B is carried onto the supplying portion of the carrying device 2 from the upstream device (not shown), and the printed board P on the supplying portion is carried to the positioning portion, positioned in the planar and vertical directions, and fixed.

When the printed board P is positioned, according to the mounting data for the board type B stored in the RAM 17 described in Fig. 6, the CPU 16 controls the mounting heads 10, 11 of both the beams 7, 8 so that these pick up electronic components from the component feeding devices 3, 5 and mount the components on the printed board P in parallel (not "synchronously").

In this case, when the production of the B-type printed board is to start, as shown in the component disposition data of Figs. 3 and 4, since the component feeding units for the B-type printed board and the component feeding units common to all the types are disposed on the component feeding device 5 and the component feeding device 3 in advance, the production of the B-type printed board is started without the changing work i.e., the replacement work of the component feeding unit by the operator.

Furthermore, the CPU 16 controls both the beams 7, 8 so that these do not come close to each other in the Y direction more than need, and controls both the mounting heads 10, 11 so that these do not come close to each other in the X direction more than need, thereby preventing the mounting heads 10, 11 of both the beams 7, 8 from clashing against each other.

First, in the step numbers "0001" to "0004" of the mounting data shown in Fig. 6, the mounting head 10 (the head number "1" in Fig. 6) mounted on the beam 7 on the rear side picks up electronic components for the B-type printed board from the component feeding device 5 in order, and in parallel, in the step numbers "0005" to "0008", the mounting head 11 (the head number "2" in Fig. 6) mounted on the beam 8 on the front side picks up electronic components from the component feeding device 3 in order. In detail, in the step number "0001", the suction nozzle 101 of the nozzle number "1" of the mounting head 10 mounted on the beam 7 on the rear side picks up an electronic component from the component feeding unit 13 of the feeder lane number (FDR number) "114", and in parallel, in the step number "0005", the suction nozzle 111 of the nozzle number "1" of the mounting head 11 mounted on the beam 8 on the front side picks up an electronic component from the component feeding unit 13 of the feeder lane number (FDR number) "218". In this manner, each of the mounting heads 10, 11 picks up four electronic components by suction in the corresponding step numbers. At this time, in the similar manner to the production of the board type A, the start of picking up the component by suction by the mounting head 11 on the front side and the start of picking up the component by suction by the mounting head 10 on the rear side, and the completion of picking up all the components by suction by the mounting head 11 on the front side and the completion of picking up all the components by suction by the mounting head 10 on the rear side may not be at the same time.

After the picking of the electronic components, in the similar manner to the production of the A-type printed board described above, both the mounting heads 10, 11 move, and during the moving, the recognition processing device 27 performs the recognition processing and recognizes the positional shifts of the electronic components relative to the suction nozzles.

Then, each of the positional recognition results about the printed board P and each of the component recognition processing results are added to the mounting coordinates in the mounting data, and each of the suction nozzles 101, 111 mounts the electronic component on the printed board P after the correction of the positional shift. In detail, the suction nozzles 101 of the mounting head 10 mounted on the beam 7 on the rear side holding the electronic components in the step numbers "0001" to "0004" by suction correct the positional shifts and mount the components on the printed board P sequentially. And in parallel with this, the suction nozzles 111 of the mounting head 11 mounted on the beam 8 on the front side holding the electronic components in the step numbers "0005" to "0008" by suction correct the positional shifts and mount the components on the printed board P sequentially.

Then, the electronic components stored in the component feeding device 5 and the component feeding device 3 are picked up by the mounting head 10 on the rear side and the mounting head 11 on the front side in parallel, and mounted on each of printed boards P sequentially. When the mounting of the electronic components on one printed board P is completed, the printed board P is discharged by the carrying device 2, other printed board is carried in from the upstream, and electronic components are mounted on the printed board P as described above.

When the production of the printed boards P of the board type B is completed, the operator presses the touch panel switches 21 displayed on the monitor 20, designates the pre-determined board type C as the type of a printed board P to be produced next, and presses the operation switch to start the production operation of a printed board of the board type C.

Then, a printed board P of the board type C is carried onto the supplying portion of the carrying device 2 from the upstream device (not shown), and the printed board P on the supplying portion is carried to the positioning portion, positioned in the planar and vertical directions, and fixed.

After the printed board P is positioned, according to the mounting data for the board type C stored in the RAM 17 described in Fig. 7, the CPU 16 controls the mounting heads 10, 11 of both the beams 7, 8 so that these pick up electronic components from the component feeding device 5 on the rear side only and mount the components on the printed board P.

In this case, when the production of the C-type printed board P is to start, as shown in the component disposition data of Figs. 3 and 4, on the component feeding device 5, the component feeding units for the C-type printed board and the component feeding units that are common to all the types are disposed in advance, and thus the production of the C-type printed board P is started without the changing work i.e., the replacement work of the component feeding units by the operator.

Furthermore, the CPU 16 controls both the beams 7, 8 so that these do not come close to each other in the Y direction more than need, and controls both the mounting heads 10, 11 so that these do not come close to each other in the X direction more than need, thereby preventing the mounting heads 10, 11 of both the beams 7, 8 from clashing against each other.

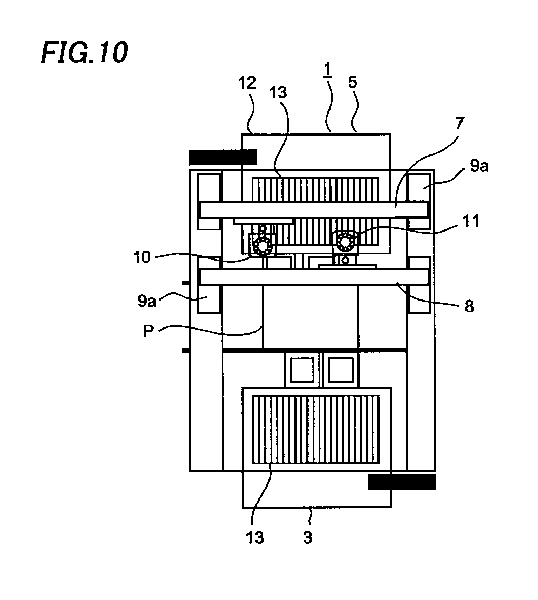

First, in the step numbers "0001" to "0004" of the mounting data shown in Fig. 7, the mounting head 10 (the head number "1" in Fig. 7) mounted on the beam 7 on the rear side picks up electronic components for the C-type printed board from the component feeding device 5 in order, and in parallel, in the step numbers "0005" to "0008", the mounting head 11 (the head number "2" in Fig. 7) mounted on the beam 8 on the front side picks up electronic components from the component feeding device 5 in order. In detail, in the step number "0001", the suction nozzle 101 of the nozzle number "1" of the mounting head 10 mounted on the beam 7 on the rear side picks up an electronic component from the component feeding unit 13 of the feeder lane number (FDR number) "101", and in parallel, as shown in Fig. 10, in the step number "0005", the suction nozzle 111 of the nozzle number "1" of the mounting head 11 mounted on the beam 8 on the front side picks up an electronic component from the component feeding unit 13 of the feeder lane number (FDR number) "117". In this manner, each of the mounting heads 10, 11 picks up four electronic components from the component feeding device 5 on the rear side by suction in the corresponding step numbers. At this time, in the similar manner to the production of the board types A, B, the start of picking up the component by suction by the mounting head 11 on the front side and the start of picking up the component by suction by the mounting head 10 on the rear side, and the completion of picking up all the components by suction by the mounting head 11 on the front side and the completion of picking up all the components by suction by the mounting head 10 on the rear side may not be at the same time.

After the picking of the electronic components, in the similar manner to the production of the printed boards of the types described above, both the mounting heads 10, 11 move, and during the moving, the recognition processing device 27 performs the recognition processing and recognizes the positional shifts of the electronic components relative to the suction nozzles.

Then, each of the positional recognition results about the printed board P and each of the component recognition processing results are added to the mounting coordinates in the mounting data, and each of the suction nozzles 101, 111 mounts the electronic component on the printed board P after the correction of the positional shift. In detail, the suction nozzles 101 of the mounting head 10 mounted on the beam 7 on the rear side holding the electronic components in the step numbers "0001" to "0004" by suction correct the positional shifts and mount the components on the printed board P sequentially. And in parallel with this, the suction nozzles 111 of the mounting head 11 mounted on the beam 8 on the front side holding the electronic components in the step numbers "0005" to "0008" by suction correct the positional shifts and mount the components on the printed board P sequentially.

Then, the electronic components stored in the component feeding device 5 are picked up by the mounting head 10 on the rear side and the mounting head 11 on the front side in parallel, and mounted on each of printed boards P of the board type C sequentially.

In parallel with the mounting of the electronic components on the C-type printed board P, on the component feeding device 3 on the front side, the operator performs the replacement work of the component feeding units by component feeding units supplying electronic components for the D-type printed board P to be produced next after the C-type printed board P and electronic components for the E-type printed board P to be produced thereafter.

In detail, as shown in Fig. 8, the component feeding units 13 for the A-type printed board P that are disposed on the feeder lanes of the numbers (FDR numbers) "201" to "203" and complete the production are replaced by the component feeding units 13 of the component ID D2000-100 etc for the D-type printed board P to be produced next. Furthermore, the component feeding unit 13 for the A-type printed board P disposed on the feeder lane of the number (FDR number) "204" and the component feeding units for the B-type printed board P disposed on the feeder lanes of the numbers (FDR numbers) "218" to "220" are replaced by the component feeding units 13 of the component ID E2000-100 etc for the E-type printed board P to be produced.

In the replacement work by the operator, one component feeding unit 13 is pulled out from the feeder base 12, and then other component feeding unit is inserted in the vacant feeder lane. Two or more component feeding units are not pulled out simultaneously, and the component feeding units 13 are replaced one by one. In detail, when the operator is about to pull two or more component feeding units 13 sequentially, for example, a sensor mounted on the feeder base 12 detects a bit of motion of the second component feeding unit. The CPU then operates corresponding to a signal from the sensor and an alarm such as a buzzer (not shown) operates to alert the operator. Simultaneously, a lock mechanism may operate so as to prevent the second or more component feeding units from being pulled out. This prevents two component feeding units next to each other from being pulled out, and prevents the operator from mistakenly inserting his/her hand in the apparatus body from a wide vacant space on the feeder base and from touching the beam 8 operating for the production of the C-type printed board P.

When the mounting of the electronic components on one printed board P of the board type C is completed, the printed board P is discharged by the carrying device 2, other printed board P is carried in from the upstream, and electronic components are mounted on the printed board P as described above. The C-type printed boards P are thus produced in parallel with the replacement work of the component feeding units on the component feeding device 3.

In this manner, in parallel with the production of the C-type printed board P, the replacement work of the component feeding units 13 for the D-type printed board and further for the E-type printed board P to be produced thereafter is achieved, so that the productivity of the electronic component mounting apparatus is enhanced compared with a case where the replacement work is performed after the completion of the production of the C-type printed boards P. Furthermore, since not only the mounting head 10 on the rear side but also the mounting head 11 on the front side pick up electronic components from the component feeding device 5 on the rear side that is on one side and mount the electronic components on a printed board sequentially, the operating ratio of the mounting head 11 is enhanced, the production efficiency is enhanced, and the mounting time is minimized.

As described above, the replacement work of the component feeding units 13 is performed in parallel with the production of the C-type printed boards P. Then, when the production of the printed boards P of the board type C is completed, the operator presses the touch panel switches 21 displayed on the monitor 20, designates the pre-determined board type D as the type of a printed board P to be produced next, and presses the operation switch to start the production operation of a printed board of the board type D.
Then, a printed board P of the board type D is carried onto the supplying portion of the carrying device 2 from the upstream device (not shown), and the printed board P on the supplying portion is carried to the positioning portion, positioned in the planar and vertical directions, and fixed.

Then, based on the mounting data shown in Fig. 9, each of the mounting heads 10, 11 picks up electronic components from each of the component feeding devices 5, 3 and mounts the electronic components on the printed board P. In detail, the mounting head 10 picks up electronic components that are common to all the board types from the component feeding device 5 in the step numbers "0001" to "0004", and mounts the electronic components on the printed board P. The mounting head 11 on the front side picks up electronic components from the replaced component feeding units supplying the electronic components for the D-type printed board, and mounts the electronic components on the printed board P, in the step numbers "0005" to "0008".

Thereafter, based on the mounting data shown in Fig. 9, each of the mounting heads 10, 11 picks up the electronic components that are common to all the board types or the electronic components for the D-type printed board from each of the component feeding devices 5, 3 and mounts the electronic components on the printed board P.

When the mounting of the electronic components on one printed board P of the board type D is completed, the printed board P is discharged by the carrying device 2, other printed board is carried in from the upstream, and electronic components are mounted on the printed board P as described above. The D-type printed boards are thus produced.

Then, when the production of the D-type printed boards P is completed, the E-type printed boards to be produced next are produced.

The above description is given as an example where electronic components are mounted on a printed board P by one electronic component mounting apparatus 1. When a printed board P is produced in a mounting line where a plurality of electronic component mounting apparatuses including the electronic component mounting apparatus 1 are linked, the component disposition data of the component feeding devices 3, 5 are set so as to avoid a need to replace the component feeding units in each of the electronic component mounting apparatuses as much as possible for the change of the board type. And simultaneously, the component disposition data and mounting data are set so that the replacement work of the component feeding units is performed in the component feeding device on one side of the electronic component mounting apparatus and the production of printed boards is continued by continuing the feeding of the electronic components from the component feeding units on the other side when the component feeding units need be replaced by others in any one of the electronic component mounting apparatuses for the change of the board type.

The component feeding units are disposed on the component feeding devices in each of the electronic component mounting apparatuses based on the component disposition data set in this manner, and each of the apparatuses is operated based on the mounting data, thereby enhancing the production efficiency of each of the beams and the productivity in the whole mounting line.

Furthermore, in the mounting line, when the replacement work of the component feeding units is needed in two or more electronic component mounting apparatuses simultaneously, the component disposition data is set so as to perform the replacement work of the component feeding units of each of the component feeding devices on the same side, for example, on the front side of each of the electronic component mounting apparatuses. This allows the operator to perform the replacement works of the component feeding units on the same side of both the electronic component mounting apparatuses, and minimizes the moving distance of the operator in the works, thereby reducing the working time.

Alternatively, the component feeding devices 3, 5 may be carts that are capable of being set in and taken out (detachable and attachable) of the electronic component mounting apparatus 1, and may include a shutter or the like, for example, by which the operator is prevented from inserting his/her hand or the like into a space where the mounting heads 10, 11 are working from a place where the component feeding device 3, 5 (cart) is taken out. Instead of the replacement of the component feeding units 13 one by one as shown in Fig. 8, the set feeding device 3, 5 may be replaced by a feeding device 3, 5 on which component feeding units 13 are previously arrayed as shown in the replaced component disposition data in Fig. 8.

In this manner, even when the feeding device 3 or 5 (cart) is replaced, the component mounting operation is effectively continued using both the mounting heads 10, 11 without stopping the production operation.

Furthermore, instead of the component feeding device 3 or the component feeding device 5, a component feeding device as a tray feeder may be mounted on one side of the electronic component mounting apparatus, the tray feeder storing a plurality of pallets (component feeding units) in the vertical direction, on which a tray having many electronic components arrayed thereon is disposed, and supplying the electronic components from this tray. When the tray is replaced by other on the tray feeder, for example, both the mounting heads 10, 11 pick up electronic components from the component feeding device on the other side as described above and mount the electronic components on a printed board P, thereby enhancing the operating ratio of the mounting heads.

Although the embodiments of the invention are described as above, the those skilled in the art would understand that various substitutions, changes or modifications are possible based on the above description, and the invention includes various substitutions, changes or modification within the scope of the invention.

In the invention, when the component feeding units are replaced, the operating ratio of the beam is enhanced and the production efficiency is enhanced.

## Claims

1. A method of mounting an electronic component by an electronic component mounting apparatus, the apparatus comprising:
a carrying device (2) having a first side and a second side and carrying a printed board (P) in a first direction;
a first component feeding device (3) placed on the first side of the carrying device (2) and comprising a plurality of component feeding units (13) supplying electronic components;
a second component feeding device (5) placed on the second side of the carrying device (2) and comprising a plurality of component feeding units (13) supplying electronic components;
a first beam (8) and a second beam (7) that are movable in a second direction;
a first mounting head (11) comprising a first suction nozzle (111) and movable along the first beam (8); and
a second mounting head (10) comprising a second suction nozzle (101) and movable along the second beam (7),
the method comprising moving the first suction nozzle (111) and the second suction nozzle (101) by moving the first beam (8), the second beam (7), the first mounting head (11) and the second mounting head (10) so that the first suction nozzle (111) and the second suction nozzle (101) pick up electronic components from the second component feeding device (5) and mount the picked up electronic components on the printed board (P) when the component feeding unit (13) of the first component feeding device (3) is replaced by other component feeding unit.

2. The method of claim 1, further comprising moving the first suction nozzle (111) and the second suction nozzle (101) so that the first suction nozzle (111) and the second suction nozzle (101) pick up electronic components from the second component feeding device (5) alternately.

3. The method of claim 1 or 2, further comprising moving the first suction nozzle (111) and the second suction nozzle (101) by moving the first beam (8), the second beam (7), the first mounting head (11) and the second mounting head (10) so that the first suction nozzle (111) and the second suction nozzle (101) pick up electronic components from the first component feeding device (3) and the second component feeding device (5) and mount the picked up electronic components on the printed board respectively when the component feeding units (13) of the first component feeding device (3) and the second component feeding device (5) are not replaced by other component feeding units.

4. An electronic component mounting apparatus comprising:
a carrying device (2) having a first side and a second side and carrying a printed board (P) in a first direction;
a first component feeding device (3) placed on the first side of the carrying device (2) and comprising a plurality of component feeding units (13) supplying electronic components;
a second component feeding device (5) placed on the second side of the carrying device (2) and comprising a plurality of component feeding units (13) supplying electronic components;
a first beam (8) and a second beam (7) that are movable in a second direction;
a first mounting head (11) comprising a first suction nozzle (111) and movable along the first beam (8);
a second mounting head (10) comprising a second suction nozzle (101) and movable along the second beam (7), and
a control device (16) controlling the movement of the first beam (8), the second beam (7), the first mounting head (11) and the second mounting head (10) so that the first suction nozzle (111) and the second suction nozzle (101) pick up electronic components from the second component feeding device (5) and mount the picked up electronic components on the printed board (P) when the component feeding unit (13) of the first component feeding device (3) is replaced by other component feeding unit.

5. The electronic component mounting apparatus of claim 4, wherein the control device (16) controls the movement of the first suction nozzle (111) and the second suction nozzle (101) so that the first suction nozzle (111) and the second suction nozzle (101) pick up electronic components from the second component feeding device (5) alternately.

6. The electronic component mounting apparatus of claim 4 or 5, wherein the control device (16) controls the movement of the first beam (8), the second beam (7), the first mounting head (11) and the second mounting head (10) so that the first suction nozzle (111) and the second suction nozzle (101) pick up electronic components from the first component feeding device (3) and the second component feeding device (5) and mount the picked up electronic components on the printed board respectively when the component feeding units (13) of the first component feeding device (3) and the second component feeding device (5) are not replaced by other component feeding units.
